(19) Europäisches Patentamt

European Patent Office

Office européen des brevets

(11) Veröffentlichungsnummer: **0 062 167**
**B2**

(12) **NEUE EUROPÄISCHE PATENTSCHRIFT**

(45) Veröffentlichungstag der neuen Patentschrift:
**11.04.90**

(21) Anmeldenummer: **82101702.7**

(22) Anmeldetag: **04.03.82**

(51) Int. Cl.⁵: **H 05 K 5/02,** H 01 G 1/02

(54) **Elektrisches Bauelement, das zentriert und justiert in einem Gehäuse untergebracht ist.**

(30) Priorität: **31.03.81 DE 3112906**
**14.08.81 DE 3132243**

(43) Veröffentlichungstag der Anmeldung:
**13.10.82 Patentblatt 82/41**

(45) Bekanntmachung des Hinweises auf die :
Patenterteilung:
**05.11.86 Patenblatt 86/45**

(45) Bekanntmachung des Hinweises auf die
Entscheidung u¨ber den Einspruch:
**11.04.90 Patentblatt 90/15**

(84) Benannte Vertragsstaaten:
**DE**

(56) Entgegenhaltungen:
**DE-A-2 353 154**
**DE-A-2 715 516**
**DE-B-1 514 514**
**DE-C- 586 366**
**DE-U-1 911 606**
**DE-U-7 021 001**
**US-A-3 737 729**
**US-A-3 842 188**

(73) Patentinhaber: **Siemens Aktiengesellschaft**
**Wittelsbacherplatz 2**
**D-8000 München 2 (DE)**

(72) Erfinder: **Linse, Heinrich, Dipl.-Ing.**
**Rodauer Weg 23b**
**D-8411 Lappersdorf (DE)**
Erfinder: **Kodal, Tassilo**
**Ahornstrasse 1**
**D-8411 Oppersdorf (DE)**
Erfinder: **Kraus, Hubert**
**Agnesstrasse 11**
**D-8400 Regensburg (DE)**

EP 0 062 167 B2

## Beschreibung

Die Erfindung betrifft ein elektrisches Bauelement, mit einem Gehäuse in Form eines Bechers mit rechteckigem Querschnitt, in welchem das Bauelement untergebracht ist, Stromzuführungsdrähte aufweist, die aus der Öffnung des Bechers in gleicher Richtung herausragen (radiale Bedrahtung) und in dem Becher mit ausgehärtetem Vergußmaterial festgelegt ist, wobei der Becher wenigstens an zwei gegenüberliegenden Seiten, insbesondere an den gegenüberliegenden schmalen Seiten, mit einstückig angeformten Laschen aus dem gleichen Material versehen ist und diese Laschen in das Innere des Bechers umgebogen sind, durch ihre Federkraft das Bauelement klemmend halten und beim Vergießen mit Vergußmaterial und Aushärten desselben als Zentrierung und Justierung für das Bauelement dienen.

Ein elektrisches Bauelement mit diesen Merkmalen ist im DE-U- 7 021 001 beschrieben. Bei diesem bekannten Bauelement sind die Haltelaschen gabelförmig ausgeführt mit dem Zweck, daß die Stromzuführungsdrähte des Bauelementes in dem gabelförmigen Teil der Haltelaschen gehalten werden. Für den Zusammenbau des elektrischen Bauelementes mit dem Gehäuse bedeutet dies, daß die Haltelaschen zunächst senkrecht nach oben stehen, während das elektrische Bauelement in den Becher eingesetzt wird, und daß erst danach die Haltelaschen in das Innere des Bechers umgebogen werden. Der Zentrierungseffekt dieser Haltelaschen ist demzufolge gering. Um dies so weit möglich zu verbessern, wird in der genannten Vorveröffentlichung vorgeschlagen, die Schlitze der Haltelaschen schmäler als den Durchmesser des Stromzuführungsdrahtes auszubilden, so daß eine Klemmwirkung erzielbar ist, die ausreicht, den Wickelkörper des Bauelementes in allen Koordinatenebenen zu fixieren, wobei die Schlitzebenen parallel oder zur besseren Einkerbung der Laschen in den Draht messerartig ausgeführt sind. Abgesehen davon, daß diese Ausführung der Haltelaschen zusätzliche Probleme beim Umbiegen der Haltelaschen und dem Erfassen der Stromzuführungsdrähte bringt, bedeutet diese Ausführungsform aber auch, daß während des Einfüllens flüssiger Vergußmasse in den Becher eine Verschiebung des Bauelementes in horizontaler Ebene nach wie vor möglich ist.

In dem Buch "Siemens Bauelemente, Technische Erläuterungen und Kenndaten für Studierende", 2. Auflage, April 1977, sind auf den Seiten 439 bis 462 ebenfalls elektrische Bauelemente beschrieben und auf den Seiten 455, 461 und 462 abgebildet, die zum Teil die Merkmale des einleitend angegebenen elektrischen Bauelementes erfüllen.

In der DE-PS 1 299 073 ist ein Verfahren zum Einbau eines elektrischen Kondensators mit stirnseitigen Kontaktflächen oder eines ähnlichen mit Kontaktflächen versehenen elektrischen Bauelementes in ein becherartiges Gehäuse beschrieben. Bei diesem Verfahren werden die Stromzuführungsdrähte durch im Boden des becherartigen Gehäuses befindliche Löcher durchgeführt, bis sie aus der Öffnung des Gehäuses herausragen, wonach die mechanische und elektrische Verbindung der Stromzuführungsdrähte mit den am Bauelement befindlichen Metallschichten beispielsweise durch Löten erfolgt. Nachdem das so kontaktierte Bauelement wieder im Becher untergebracht ist, wird dieser einer Vergießeinrichtung zugeführt, in der der freie Raum zwischen dem Bauelement und den Gehäusewandungen des Bechers vergossen wird.

Elektrische Bauelemente in Sinne der Erfindung sind in erster Linie elektrische Kondensatoren in Form von Rundwickeln oder von Flachwickeln oder Schichtkondensatoren, das sind solche, bei denen die dielektrisch wirksamen Schichten mit alternierend nach gegenüberliegenden Seiten endenden Metallschichten übereinander gestapelt sind, wobei alle diese Kondensatoren an gegenüberliegenden Stirnflächen mit Metallschichten versehen sind, hergestellt beispielsweise durch Metallspritzverfahren, an denen die Stromzuführungsdrähte angelötet oder durch Punktschweißen befestigt sind. Diese Stromzuführungsdrähte stehen in radialer Richtung von den Bauelementen ab (radiale Bedrahtung), so daß diese Bauelemente in einem Gehäuse in Form eines rechteckigen Bechers untergebracht werden können. Andere Bauelemente sind beispielsweise Keramikkondensatoren, elektrische Widerstände, Spulen und auch Halbleiterbauelemente.

Beim Einbau solcher Bauelemente in den aus Isolierstoff bestehenden Becher müssen die Anschlußelemente radial in einem bestimmten Abstand voneinander (festgelegtes Rastermaß) herausgeführt sein. Durch die unterschiedlichen Abmessungen und die bestimmenden Fertigungstoleranzen der Bauelemente ist die Forderung nach einem festgelegten Rastermaß der Stromzuführungsdrähte nur mit sehr großem Aufwand zu erfüllen, wie dies beispielsweise bei der angegebenen DE-PS 1 299 073 beschrieben ist.

Zum Feuchteschutz und zur Festlegung des Bauelementes im Becher wird dieser mit Vergußmasse, beispielsweise mit im großen Umfang auf dem Markt befindlichen Epoxidharzen vergossen und diese Vergußmasse dann ausgehärtet. Dabei werden diese mit Stromzuführungsdrähten versehenen Bauelemente, insbesondere elektrische Schichtkondensatoren in einen vorgeformten Kunststoffbecher eingeführt, der bereits mit noch flüssiger Vergußmasse vorgefüllt ist und nach dem Einstecken des Bauelements mit dieser Vergußmasse vollgefüllt wird. Da die Vergußmasse während des Aushärtevorgangs eine dünnflüssige Phase durchläuft, besteht die Gefahr, das das elektrische Bauelement, wenn es nicht im Gehäuse fixiert ist, seine Lage im Becher ändert. Es ist bekannt, für diese Zentrierung und Justierung des Bauelements im Becher an der Innenwandung des Bechers Führungsrippen vorzusehen. Solche Führungsrippen setzen aber voraus, daß die Fertigungstoleranzen des elektrischen Bauelements nur sehr gering sind.

Unter bestimmten Bedingungen wurde das Einklemmen der elektrischen Bauelemente durch eine besondere Formgebung der schmalen Seitenwände des Bechers verwirklicht, so z. B. durch einen im Becher am oberen Ende der schmalen Seitenwände rechtwinklig angespritzten Führungslappen mit einem zentrierend wirkenden Profil oder durch längs der Innenwände der schmalen Seitenflächen angespritzte federnde Lippen. Diese bereits bekannten Fixierhilfen haben aber den Nachteil, daß sie sich spritztechnisch nur schwer realisieren lassen, beispielsweise wegen der auftretenden Entformung, und darüber hinaus nur kleine Toleranzen zwischen Bauelementelänge und Becherinnenlänge federnd ausgleichen können.

Der vorliegenden Erfindung liegt die Aufgabe zugrunde, ein elektrisches Bauelement anzugeben, bei dessen Herstellung die Toleranzen der Abmessungen des elektrischen Bauelementes größer sein können, das bis zur Aushärtung des Vergußmaterials zentriert und justiert seine Lage im Becher beibehält und bei dem sowohl der Spritzvorgang des Bechers als auch der Einbau des elektrischen Bauelementes in den Becher auf einfache Weise vorgenommen werden kann.

Zur Lösung dieser Aufgabe ist das elektrische Bauelement der eingangs angegebenen Art erfindungsgemäß dadurch gekennzeichnet, daß die Laschen von der öffnung über den Rand des Bechers derart weit in das innere des Bechers umgebogen sind, daß das Bauelement zwischen den Außenseiten der Laschen und durch ihre Federkraft klemmend gehalten ist.

Der als Gehäuse dienende Becher gehört praktisch mit zum elektrischen Bauelement, weil durch ihn die elektrischen Eigenschaften des Bauelementes beibehalten werden, indem Einflüsse aus der Umgebung (Feuchtigkeit, aggressive Gase usw.) abgehalten werden.

Die Ausgestaltung des Bechers des elektrischen Bauelements gemäß der Erfindung gewährleistet, daß die bei den bekannten Ausführungen auftretenden Mängel und Nachteile vermieden werden und darüber hinaus die der Erfindung zugrunde liegende Aufgabe in befriedigender Weise gelöst wird.

Gemäß einer bevorzugten Ausführungsform sind die Laschen mit V-förmigen Ausschnitten versehen, in denen die Stromzuführungsdrähte des Bauelements eingeführt sind. Es entstehen durch das Umbiegen solcher Laschen in das Innere des Bechers V-förmige Gabeln, die die Zentrierung des Bauelements in Richtung der Breite des Bechers gewährleisten, während die Zentrierung des Bauelements in Längsrichtung des Bechers durch die beiden Laschen bewirkt wird.

Es ist auch möglich und liegt im Rahmen der vorliegenden Erfindung, einstückig angeformte Laschen an den Längsseiten des Bechers oder auch an allen vier Seiten desselben anzubringen.

Gemäß einer weiteren bevorzugten Ausführungsform der Erfindung sind die Laschen auf ihrer Außenseite mit erhabenen Führungsleisten versehen, die zum Ende der Laschen hin konvergierend verlaufen und zwischen denen die Stromzuführungsdrähte des Bauelements geführt sind. Durch das Einbiegen derartig geformter Laschen sind die Führungsleisten zum Bauelement hin gerichtet. Auch diese Ausführungsform gewährleistet eine Zentrierung des Bauelements in Richtung der Breite des Bechers neben der Zentrierung in Längsrichtung des Bechers, die durch die umgebogenen Laschen erfolgt.

Um im Bedarfsfall einen Abstand zwischen dem Bauelement und dem Boden des Bechers zu gewährleisten, damit das Bauelement nicht unmittelbar mit der Innenseite des Bechers in Berührung kommt und der gebildete freie Raum vollständig mit Vergußmasse ausgefüllt werden kann, können die Stromzuführungsdrähte das Bauelement in Richtung auf den Becherboden hin um einen gewissen Betrag überragen.

Die oben genannte Ausführungsform, bei der die Laschen an ihren Enden mit V-förmigen Ausschnitten versehen sind, in denen die Stromzuführungsdrähte des Bauelements eingeführt sind, könnte in gewissen Fällen noch nicht ausreichend sein, um damit eine eindeutig zu den Längswänden parallele Führung des Bauelements während des Einsetzens in den Becher zu gewährleisten.

Ähnliches gilt auch für die oben weiterhin genannte Möglichkeit, die Laschen auf ihrer Außenseite mit erhabenen Führungsleisten zu versehen, die zum Ende der Laschen hin konvergierend verlaufen und zwischen denen die Stromzuführungsdrähte des Bauelements geführt sind. Es kommt hinzu, daß bei der Herstellung solcher Führungsleisten ein zusätzlicher Aufwand nötig ist.

Eine weitere bevorzugte Ausführungsform der Erfindung ist deshalb erfindungsgemäß dadurch gekennzeichnet, daß die Laschen V-förmig und damit Rinnen bildend geformt sind, in denen die Stromzuführungsdrähte des Bauelements eingeführt sind.

Durch diese Ausführungsform ist sowohl eine über die gesamte Einführungsstrecke parallele Führung der Bauelemente als auch eine vereinfachte Herstellung des becherförmigen Gehäuses möglich.

Die Erfindung wird nachfolgend unter Bezugnahme auf die Zeichnungen näher erläutert. Es zeigen:

Fig. 1 eine Seitenansicht im Schnitt eines elektrischen Bauelements,

Fig. 2 einen rechteckförmigen Becher mit einstückig angeformten Laschen,

Fig. 3 den Becher nach Fig. 2 im Schnitt mit nach innen abgebogenen Laschen,

Fig. 4 den Becher gemäß Fig. 3 bei beginnendem Einschieben des Bauelements,

Fig. 5 eine andere Ausführungsform einer Lasche,

Fig. 6 eine weitere Ausführungsform der Lasche,

Fig. 7 die Lasche gemäß Fig. 6, von oben gesehen,

Fig. 8 eine Seitenansicht im Schnitt eines elektrischen Bauelements,

Fig. 9 einen rechteckförmigen Becher mit einstückig angeformten Laschen

Fig. 10 den Becher nach Fig. 9 in Draufsicht vor dem Umbiegen der Laschen und

Fig. 11 den Becher gemäß Fig. 8 nach dem Umbiegen der Laschen und mit eingesetztem Bauelement in Draufsicht.

In den Figuren sind gleiche Teile mit gleichen Bezugszeichen versehen.

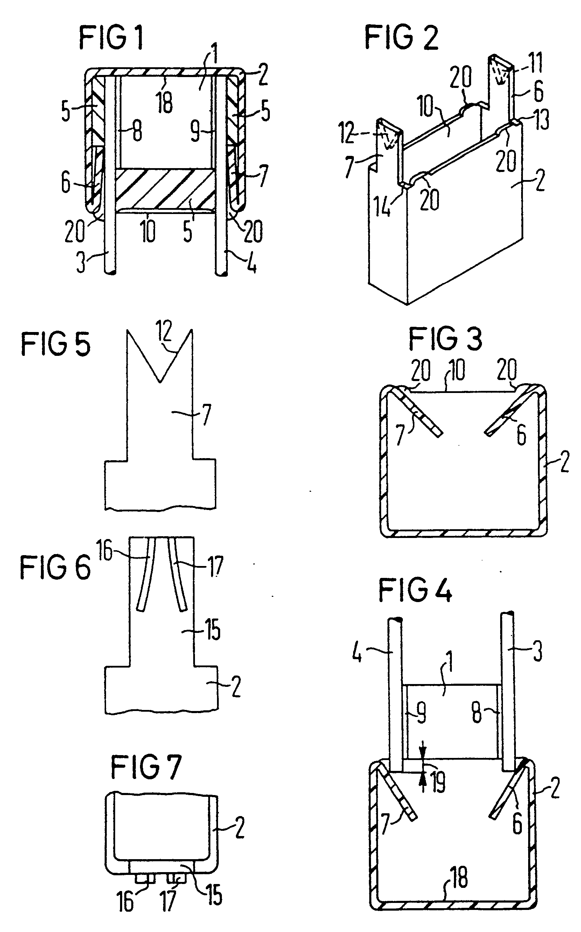

In Fig. 1 ist das elektrische Bauelement 1, das an seinen Stirnseiten Metallschichten 8 und 9 aufweist, mit Stromzuführungsdrähten 3 und 4 versehen, die an den Metallschichten 8 und 9 vorzugsweise durch Löten befestigt sind. Die Stromzuführungsdrähte 3 und 4 ragen in gleicher Richtung aus der Offnung 10 des Bechers 2 heraus, in welchen das Bauelement 1 eingesetzt ist. Der zwischen dem Becher 2 und dem Bauelement 1 samt den Stromzuführungsdrähten 3 und 4 verbliebene Hohlraum ist mit Vergußmasse 5 ausgefüllt, die ausgehärtet ist. Von der Offnung 10 und über den Rand des Bechers 2 aus sind die Laschen 6 und 7 in das Innere des Bechers abgebogen und liegen an den Stromzuführungsdrähten 3 und 4 an.

Aufgrund der Länge der Laschen 6 und 7 können auch größere Abweichungen des Bauelements 1 von der Nennabmessung der Bauementelängen mit Sicherheit durch unterschiedlich weites Abbiegen der Laschen 6 und 7 abgefangen werden. Es können auch in Bechern gleichgroßer Abmessungen elektrische Bauelemente, vorzugsweise Schichtkondensatoren, unterschiedlicher Abmessung in Längsrichtung eingesetzt werden. Auch dies wird durch die nach innen umgebogenen Laschen ausgeglichen.

Im voll eingesetzten Zustand bewirkt die Federkraft der Laschen 6 und 7 eine Fixierung des Bauelementes sowohl gegen das Hochschwimmen und/oder seitliches Verschieben des Bauelementes 1 in der Vergußmasse während des Aushärtens, wenn der Becher 2 gehalten wird, als auch gegen das Abgleiten des Bechers 2 bei an den Drähten 3 und 4 gehaltenem, z. B. gegurtetem elektrischen Bauelement 1. In Fig. 1 ist gezeigt, daß das Bauelement 1 unmittelbar am Boden 18 des Bechers 2 anliegt.

Am Becher 2 sind an sich bekannte Abstandhalter 20 vorhanden, die dazu bestimmt sind, das elektrische Bauelement beim Einbau in eine gedruckte Schaltungsplatte in einem gewissen Abstand zu dieser Platte zu halten.

In Fig. 2 ist ein rechteckförmiger Becher 2 gezeigt, der im Bereich seiner Öffnung 10 mit den beschriebenen Abstandhaltern 20 versehen ist. An den schmalen Seiten 13 und 14 des Bechers 2 sind Laschen 6 und 7 einstückig angeformt. Ein solcher Becher wird in einfacher Weise durch Spritzgußtechnik aus Isoliermaterial hergestellt.

In Fig. 2 ist ferner angedeutet, daß die Laschen 6 und 7 V-förmige Ausschnitte 11 und 12 aufweisen können, wie dies in Fig. 5 deutlicher dargestellt ist.

Fig. 3 zeigt, daß die Laschen 6 und 7 in das Innere des Bechers abgebogen sind. Falls die Laschen 6 und 7 mit V-förmigen Ausschnitten 11 und 12 versehen sind, so bilden diese Ausschnitte V-förmige Gabeln, in die (vgl. Fig. 4) die Anschlußdrähte 3 und 4 des Bauelements 1 eingreifen, so daß dadurch eine Zentrierung erfolgt. Ohne solche Vförmige Ausschnitte 11 und 12 bewirken die nach innen abgebogenen Laschen 6 und 7 eine Zentrierung des Bauelements in Richtung seiner Längsachse.

In Fig. 4, in der gewissermaßen der Beginn des Einschiebvorgangs des Bauelements 1 in den Becher 2 dargestellt ist, ist darüber hinaus gezeigt, daß die Stromzuführungsdrähte 3 und 4 das Bauelement 1 um einen gewissen Betrag überragen, so daß ein Abstand 19 des Bauelements 1 vom Boden 18 des Bechers 2 gewährleistet ist.

Fig. 5 zeigt die an der Schmalseite 14 des Bechers 2 (siehe Fig. 2) einstückig angeformte Lasche 7, die mit einem V-förmigen Einschnitt 12 versehen ist. Zweck und Wirkungsweise dieses Einschnittes ist oben bereits beschrieben.

In ähnlicher Weise wirken die in den Figuren 6 und 7 an der Außenseite der Lasche 15 angeformten erhabenen Führungsleisten 16 und 17. Diese Führungsleisten verlaufen in Richtung auf das Ende der Lasche hin konvergierend, so daß beim Einbiegen dieser Lasche 15 und selbstverständlich auch der in gleicher Weise ausgebildeten Lasche der gegenüberliegenden schmalen Seite eine in Richtung der Breite des Bechers 2 zentrierend wirkende Führung vorliegt. Die mit den Führungsleisten 15 und 17 versehene Lasche 15 kann ebenfalls bei der Herstellung des Bechers 2 in Spritzgußtechnik erzeugt werden.

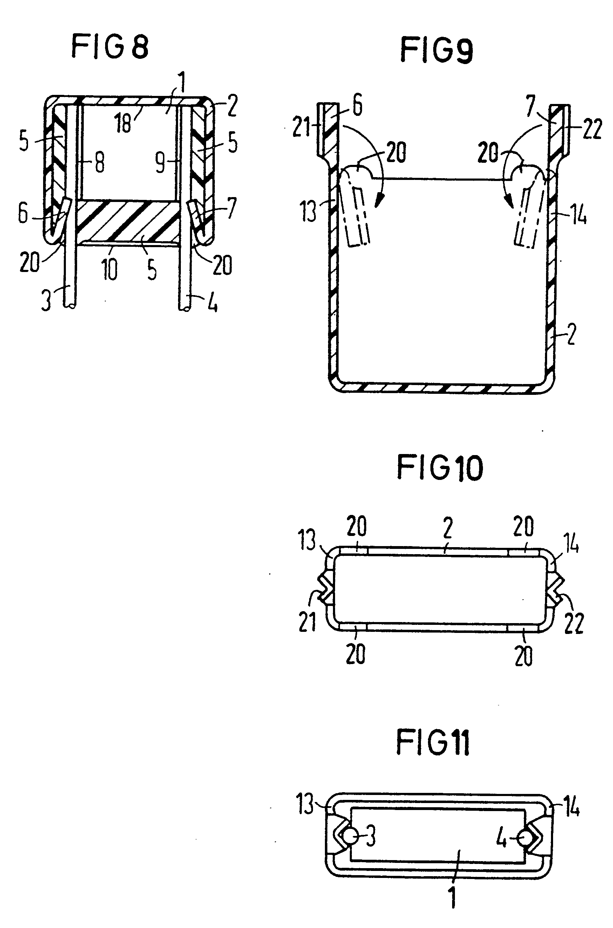

In Fig. 8, die fast der Fig. 1 entspricht, ist das elektrische Bauelement 1, das an seinen Stirnseiten Metallschichten 8 und 9 aufweist, mit Stromzuführungsdrähten 3 und 4 versehen, die an den Metallschichten 8 und 9 vorzugsweise durch Löten befestigt sind. Die Stromzuführungsdrähte 3 und 4 ragen in gleicher Richtung aus der Offnung 10 des Bechers 2 heraus, in welchen das Bauelement 1 eingesetzt ist. Der zwischen dem Becher 2 und dem Bauelement 1 samt den Stromzuführungsdrähten 3 und 4 verbliebene Hohlraum ist mit Vergußmasse 5 ausgefüllt, die ausgehärtet ist. Von der Offnung 10 her und über den Rand des Bechers 2 sind die Laschen 6 und 7 in das Innere des Bechers 2 umgebogen und liegen an den Stromzuführungsdrähten 3 und 4 an.

Das Bauelement 1 liegt - wie in Fig. 8 gezeigt am Boden 11 des Bechers 2 an. Es ist aber auch möglich, wie oben beschrieben, daß die Stromzuführungsdrähte das Bauelement um einen gewissen Betrag überragen, so daß ein Abstand des Bauelements 1 vom Boden 18 des Bechers 2 gewährleistet ist.

Am Becher 2 sind an sich bekannte Abstandshalter 20 vorhanden, die dazu bestimmt sind, das elektrische Bauelement beim Einbau in eine gedruckte Schaltungsplatte in einem gewissen Abstand zu dieser Platte zu halten.

In den Figuren 9, 10 und 11 ist gezeigt, daß an den schmalen Seiten 13 und 14 des rechteckigen Bechers 2 die Laschen 6 und 7 einstückig angeformt sind. Diese Laschen 6 und 7 sind V-förmig geformt und bilden auf diese Weise V-förmige Rinnen 21 und 22.

Die beiden Peile in Fig. 9 deuten an, daß die Laschen 6 und 7 in das Innere des Bechers 2 umgebogen sind.

Fig. 10 zeigt eine Draufsicht auf den Becher vor diesem Umbiegen, während Fig. 11 den Becher nach dem Umbiegen und mit eingesetztem Bauelement 1 zeigt.

Die Praxis hat gezeigt, daß durch die vorliegende Erfindung das Bauelement innerhalb des Bechers sowohl in Längsals auch in Querrichtung eindeutig zentriert und während des Vergießens mit dem Vergußmaterial 5 und des Aushärtens desselben festgelegt ist.

## Patentansprüche

1. Elektrisches Bauelement (1) mit einem Gehäuse in Form eines Bechers (2) mit rechteckigem Querschnitt, in welchem das Bauelement (1) untergebracht ist, Stromzu führungsdrähte (3, 4) aufweist, die aus der Öffnung (10) des Bechers (2) in gleicher Richtung herausragen (radiale Bedrahtung) und in dem Becher (2) mit ausgehärtetem Vergußmaterial festgelegt ist, wobei der Becher (2) wenigstens an zwei gegenüberliegenden Seiten, insbesondere an den gegenüberliegenden schmalen Seiten (13, 14), mit einstückig angeformten Laschen (6, 7, 15) aus dem gleichem Material versehen ist und diese Laschen in das Innere des Bechers (2) umgebogen sind, durch ihre Federkraft das Bauelement (1) klemmend halten und beim Vergießen mit Vergußmaterial (5) und Aushärten desselben als Zentrierung und Justierung für das Bauelement (1) dienen, dadurch gekennzeichnet, daß die Laschen (6, 7, 15 von der öffnung (10) über den Rand des Bechers (2) derart weit in das Innere des Bechers (2) umgebogen sind, daß das Bauelement (1) zwischen den Außenseiten der Laschen und durch Ihre Federkraft klemmend gehalten ist.

2. Elektrisches Bauelement mit einem Gehäuse nach Anspruch 1, dadurch gekennzeichnet, daß die Laschen (6, 7) mit V-förmigen Ausschnitten (11, 12) versehen sind, in denen die Stromzuführungsdrähte (13, 14) des Bauelements (1) eingeführt sind.

3. Elektrisches Bauelement mit einem Gehäuse nach Anspruch 1, dadurch gekennzeichnet, daß die Laschen (15) auf ihrer Außenseite mit erhabenen Führungsleisten (16, 17) versehen sind, die zum Ende der Laschen (15) hin konvergierend verlaufen und zwischen denen die Stromzuführungsdrähte (3, 4) des Bauelementes (1) geführt sind.

4. Elektrisches Bauelement mit einem Gehäuse nach Anspruch 1, dadurch gekennzeichnet, daß die Laschen (6, 7) V-förmig und damit Rinnen (21, 22) bildend geformt sind, in denen die Stromzuführungsdrähte (3, 4) des Bauelementes (1) eingeführt sind.

5. Elektrisches Bauelement mit einem Gehäuse nach einem der Ansprüche 1 bis 4, dadurch gekennzeichnet, daß die Stromzuführungsdrähte (3, 4) das Bauelement (1) in Richtung auf den Boden (18) des Bechers (2) um einen Betrag überragen und damit einen Abstand (19) des Bauelementes (1) vom Boden (18) des Bechers (2) gewährleisten.

## Revendications

1. Composant électrique (1) avec un boîtier de la forme de godet (2) à section transversale rectangulaire, dans lequel est logé le composant (1) qui comporte des fils d'amenée du courant (3, 4) qui sortent de l'ouverture (10) du godet (2) suivant une même direction (câblage radial) et qui sont fixés dans le godet (2) avec un matériau coulable durçi, le godet (2) ètant pourvu, au moins sur deux côtés opposés, de préférence sur les deux côtés opposés et étroits (13, 14), de pattes (6, 7, 15) conformées d'une pièce et avec le même matériau, lesdites pattes étant recourbées vers l'intérieure du godet (2), maintenant par coincement le composant (1) grâce à leur force élastique, et servant, lors de la coulée du matériau coulable (5) et du durcissement de ce dernier, au centrage et à l'ajustement du composant (1), caractérisé par le fait que les pattes (6, 7, 15) sont repliés de I 'ouverture (10) par-dessus le bord du godet (2) dans le godet (2) à un niveau tel que le composant (1) est maintenu coincé entre les côtés extérieurs despattes et grâce à la force élastique de celles-ci.

2. Composant électrique avec un boîtier, selon la revendication 1, caractérisé par le fait que les pattes (6, 7) sont pourvues d'entailles (11, 12) en forme de V, dans lesquelles sont introduits les fils d'amenée du courant (13, 14) du composant (1).

3. Composant électrique avec un boîtier, selon la revendication 1, caractérisé par le fait que les pattes (15) sont pourvues, sur leur côté extérieur, des réglettes de guidage saillantes (16, 17) qui convergent vers l'extrémité des pattes (15) et entre lesquelles sont guidés les fils d'amentée du courant (3, 4) du composant (1).

4. Composant électrique avec un boîtier, selon la revendication 1, caractérisé par le fait que les pattes (6, 7) ont la forme d'un V et sont conformées en gouttiéres (21, 22) dans lesquelles sont introduits les fils d'amenée du courant (3, 4) du composant (1).

5. Composant électrique avec un boîtier, selon l'une des revendications 1 à 4, caractérisé par le fait que les fils d'amenée du courant (3, 4) débordent le composant (1) d'une certaine quantité en direction du fond (18) du godet (2) et assurent ainsi une certaine distance (19) entre le composant (1) et le fond (18) du godet (2).

## Claims

1. An electrical component (1), with a casing in the form of a cup (2) which has a rectangular cross-section and in which the component (1) is accommodated, possesses current supply wires (3, 4), which protrude from the opening (10) of the cup (2) in the same direction (radial wiring) and is fixed in the cup (2) by means of hardened insulating material, where on at least two opposite sides, in particular on the opposite narrow sides (13, 14) the cup (2) is provided with integral lugs (6, 7, 15) of the same material and said lugs are bent into the interior of the cup (2) and by means of their spring force retain the component (1) in a clamping fashion and during the casting and hardening of the insulating material (5) serve as centering and adjusting members for the component (1), characterised in that the lugs (6, 7, 15) are bent from the opening (10) over the edge of the cup (2) into the inside of the cup (2) to such an extent that the component (1) is clamped between the outer sides of the lugs and by means of their spring force.

2. An electrical component with a casing as claimed in Claim 1, characterised in that the lugs (6, 7, 15) are provided with V-shaped notches (11, 12), into which the current supply wires (13, 14) of the component (1) are inserted.

3. An electrical component with a casing as claimed in Claim 1, characterised in that on their outer side the lugs (15) are provided with raised guide strips (16, 17) which converge towards the end of the lugs (15) and between which the current supply wires (3, 4) of the component (1) are guided.

4. An electrical component with a casing as claimed in Claim 1, characterised in that the lugs (6, 7) are V-shaped and thereby form grooves (21, 22), wherein the current supply wires (3, 4) of the component (1) are inserted.

5. An electrical component with a casing as claimed in one of Claims 1 to 4, characterised in that the current supply wires (3, 4) protrude a distance over the component (1) in the direction of the base (18) of the cup (2) and thus ensure a spacing (19) of the component (1) from the base (18) of the cup (2).

FIG 1

FIG 2

FIG 5

FIG 3

FIG 6

FIG 4

FIG 7

FIG 8

FIG 9

FIG 10

FIG 11